# EUROPEAN PATENT APPLICATION

(11) **EP 4 661 286 A1**
(43) Date of publication of application: **10.12.2025**
(21) Application number: 25162507.5
(22) Date of filing: 10.03.2025
(51) Int. Cl.: H02S 40/32, H05K 5/00

(54) **ELECTRIC POWER PRODUCT AND PHOTOVOLTAIC POWER GENERATION SYSTEM**

(30) Priority: 06.06.2024 CN 202421292299 U
(71) Applicant: Sungrow (Shanghai) Co., Ltd., Shanghai 201203 (CN)
(72) Inventor: LI, Feng, Shanghai, 201203 (CN); YU, Haiyang, Shanghai, 201203 (CN)
(74) Representative: Epping - Hermann - Fischer

(57) **Abstract**

An electric power product and a photovoltaic power generation system are provided. The electric power product includes an engagement structure, a to-be-mounted component, and a reinforcement member. The mounting portion is connected to the engagement structure, and the engagement structure is configured for engaging with an engaged component. The mounting portion is provided with a first bolt hole, and the reinforcement member is mounted on a side of the mounting portion away from the engagement structure. The reinforcement member is provided with a second bolt hole corresponding to a position of the first bolt hole.

## Description

### FIELD

The present application relates to the technical field of electric power equipment, and in particular to an electric power product and a photovoltaic power generation system.

### BACKGROUND

A photovoltaic power generation system is a power generation system that directly converts solar radiant energy into electric energy through the photovoltaic effect of a photovoltaic cell. The photovoltaic power generation system mainly includes a solar panel (a photovoltaic panel), a controller, and an electric power product. The electric power product mainly includes an engagement structure and a modular power electronic product (referred to as a to-be-mounted component hereinafter). The to-be-mounted component may be a power optimizer, a shutdown device, an inverter or the like, and the to-be-mounted component is generally assembled with an engaged component, such as a frame of a photovoltaic panel, through the engagement structure or a bolt fastener.

### SUMMARY

A problem to be solved according to the present application is how to improve the mounting stability of a to-be-mounted component.

In a first aspect, an electric power product is provided according to the present application, including an engagement structure, a to-be-mounted component, and a reinforcement member. The to-be-mounted component includes a mounting portion, the mounting portion is connected to the engagement structure, and the engagement structure is configured for engaging with an engaged component. The mounting portion is provided with a first bolt hole, and the reinforcement member is mounted on a side of the mounting portion away from the engagement structure. The reinforcement member is provided with a second bolt hole corresponding to a position of the first bolt hole, and the mounting portion is configured to be mounted to the engaged component by passing a fastener through the second bolt hole, the first bolt hole, and the engaged component.

In an embodiment, the to-be-mounted component further includes a housing body and a product body, and the product body is mounted inside the housing body; and the mounting portion is connected to the housing body, a surface of the mounting portion facing the engagement structure is higher than a surface of the housing body facing the engaged component, and the mounting portion has a mounting area for engaging with the engagement structure.

In an embodiment, the reinforcement member includes a reinforcement plate, and the reinforcement plate is attached to and is mounted to a side of the mounting portion away from the mounting area.

In an embodiment, the reinforcement member further includes a first positioning member, and the first positioning member is provided on a side of the reinforcement plate facing the mounting portion; and the mounting portion is provided with a second positioning member, the first positioning member and the second positioning member are connected to each other in a positioning manner, and the position of the second bolt hole is in correspondence to the position of the first bolt hole.

In an embodiment, the to-be-mounted component further includes a radiator, the radiator is mounted to the housing body and is configured to dissipate heat from the product body inside the housing body; and the radiator extends towards the mounting portion to form the reinforcement member, and the reinforcement member is attached to a side of the mounting portion away from the mounting area.

In an embodiment, the engagement structure has an engaging area, the engaging area is configured for engaging with the engaged component, and the engagement structure and the first bolt hole are spaced apart on the mounting portion along a direction perpendicular to an engaging direction along which the engaged component is inserted into the engaging area.

In an embodiment, the engagement structure includes an engagement body, the engagement body includes two straight plate portions and one curved plate portion, two opposite ends of the curved plate portion are respectively connected to the two straight plate portions, the two straight plate portions and the curved plate portion enclose to form the engaging area, and a side of one of the two straight plate portions away from the other one of the two straight plate portions is engage with the mounting portion.

In an embodiment, the engagement structure further includes a first engagement part and a second engagement part, the first engagement part and the second engagement part are arranged on one of the two straight plate portions of the engagement body away from the mounting portion along the direction perpendicular to the engaging direction, and when the engaged component is inserted into the engaging area, both the first engagement part and the second engagement part abut against the engaged component.

In an embodiment, the engagement structure includes at least two second engagement parts, the at least two second engagement parts are spaced apart along the direction perpendicular to the engaging direction and are arranged on the one of the two straight plate portions of the engagement body away from the mounting portion, and the at least two second engagement parts are bent and extended from the engagement body towards the engaged component.

In an embodiment, an end portion of at least one of the at least two second engagement parts away from the engagement body is parallel to the engaged component, and a size of at least another one of the at least two second engagement parts gradually decreases from the engagement body to the engaged component.

In an embodiment, the engagement body includes a third engagement part, the third engagement part is provided on the other one of the two straight plate portions of the engagement body close to the mounting portion, the third engagement part is bent and extended from the engagement body towards the engaged component, and the third engagement part is configured to abut against the engaged component.

In a second aspect, a photovoltaic power generation system is provided according to the present application, including an engaged component and the electric power product described above.

Since the photovoltaic power generation system includes the electric power product, the photovoltaic power generation system has at least all the technical effects of the electric power product, which is not repeated herein.

### BRIEF DESCRIPTION OF THE DRAWINGS

FIG. 1 is a schematic view showing the mounting structure of an electric power product and an engaged component in the conventional technology;
FIG. 2 is a schematic exploded view showing the structure of an electric power product according to an embodiment of the present application;
FIG. 3 is a schematic exploded view showing the structure of a to-be-mounted component according to an embodiment of the present application;
FIG. 4 is a schematic exploded view showing the structure of an electric power product according to an embodiment of the present application;
FIG. 5 is a first schematic exploded view showing the structure of an electric power product according to another embodiment of the present application;
FIG. 6 is a second schematic exploded view showing the structure of the electric power product according to the another embodiment of the present application;
FIG. 7 is a schematic view showing the partial explosion structure of the electric power product according to the another embodiment of the present application;
FIG. 8 is a first schematic structural view of an engagement structure according to an embodiment of the present application;
FIG. 9 is a second schematic structural view of the engagement structure according to the embodiment of the present application;
FIG. 10 is a third schematic structural view of the engagement structure according to the embodiment of the present application;
FIG. 11 is a schematic structural view of an engagement structure according to another embodiment of the present application;
FIG. 12 is a schematic structural view of the assembly of an engagement structure and an engaged component according to another embodiment of the present application; and
FIG. 13 is a schematic structural view of the assembly of an electric power product and an engaged component according to an embodiment of the present application.

**Reference numerals:**

| | | | |
|---|---|---|---|
| 1' | to-be-mounted component, | 11' | plastic housing, |
| 111' | bolt hole, | 2' | engagement structure, |
| 3' | engaged component; | | |
| 1 | reinforcement member, | 11 | reinforcement plate, |
| 111 | second bolt hole, | 12 | first positioning member, |
| 2 | engagement structure, | 21 | engagement body, |
| 22 | first engagement part, | 23 | second engagement part, |
| 24 | third engagement part, | 3 | to-be-mounted component, |
| 31 | mounting portion, | 311 | first bolt hole, |
| 312 | engagement groove, | 32 | housing body, |
| 321 | base, | 322 | end cover, |
| 33 | product body, | 34 | second positioning member, |
| 35 | radiator, | 4 | engaged component. |

### DETAILED DESCRIPTION OF THE EMBODIMENTS

In order to make the above objects, features and advantages of the present application more obvious and easy to understand, specific embodiments of the present application are described in detail below in conjunction with the drawings. It should be understood that, although some embodiments of the present application are shown in the accompanying drawings, the present application may be implemented in various forms and should not be interpreted as being limited to the embodiments described here. Instead, these embodiments are provided to provide a more thorough and complete understanding of the present application. It should be understood that, the drawings and embodiments of the present application are only for illustrative purposes, and are not intended to limit the protection scope of the present application.

In the drawings, the Z-axis denotes a vertical direction, i.e. an up-down direction, where a positive direction of the Z-axis indicates an upper side, and a negative direction of the Z-axis indicates a lower side. The X-axis denotes a horizontal direction, which is designated as a left-right direction, where a positive direction of the X-axis indicates a left side, and a negative direction of the X-axis indicates a right side. The Y-axis denotes a front-rear direction, where a positive direction of the Y-axis indicates a front side, and a negative direction of the Y-axis indicates a rear side. It should be noted that, the meanings of the Z-axis, Y-axis and X-axis are merely for the convenience of describing the present application and simplifying the description, and do not indicate or imply that a device or element referred to must have a particular orientation, or be constructed and operated in a particular orientation, which therefore should not be understood as a limitation to the present application.

The term "include" and variations thereof herein mean open inclusions, i.e. "include but not limited to"; the term "based on" means "at least partially based on"; the term "an embodiment" means "at least one embodiment"; the term "another embodiment" means "at least one another embodiment"; the term "some embodiments" means "at least some embodiments"; the term "optionally" means "in an optional embodiment". Relevant definitions of other terms are given in the following description. It should be noted that, the concepts of "first" and "second" in the present application are only used to distinguish different devices, modules or units, and are not intended to limit the order or interdependence of the functions performed by these devices, modules or units.

It should be noted that, the definitions of "an" and "multiple" in the present application are illustrative rather than restrictive, and those skilled in the art should understand that, unless otherwise clearly indicated in the context, these definitions should be understood as "one or more".

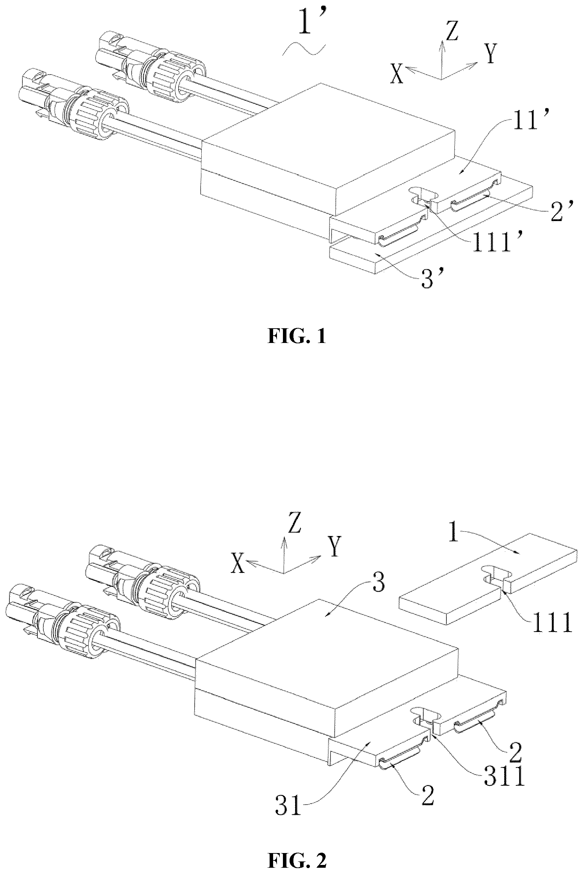

In the conventional technology, a photovoltaic power generation system refers to a power generation system that directly converts solar radiant energy into electric energy through the photovoltaic effect of a photovoltaic cell. The photovoltaic power generation system mainly includes a solar panel (a photovoltaic panel), a controller, and an electric power product. As shown in FIG. 1, the electric power product mainly includes an engagement structure 2' and a modular power electronic product (referred to as a to-be-mounted component 1' hereinafter). The to-be-mounted component 1' may be a power optimizer, a shutdown device, an inverter or the like, and the to-be-mounted component 1' is generally assembled with an engaged component 3', such as a frame of the photovoltaic panel, through the engagement structure 2' or a bolt fastener.

In a case that the to-be-mounted component 1' is mounted to the photovoltaic panel through both the engagement structure 2' and the bolt fastener, a plastic housing 11' of the to-be-mounted component 1' is expected to be provided with a mounting groove (i.e. an engaging groove) matching the engagement structure 2', and to be provided with a bolt hole 111' between two engagement structures 2' for the bolt fastener to pass through. In this way, the mounting requirements in different situations can be satisfied, and the assembling stability of the to-be-mounted component 1' and the engaged component 3' can be further improved.

During actual mounting, in the case that the to-be-mounted component 1' is mounted to the engaged component 3' through the engagement structures 2' and the bolt fastener, the two engagement structures 2' are located under the plastic housing 11' of the to-be-mounted component 1', that is, the plastic housing 11' is mounted to the engaged component 3' through the two engagement structures 2' under the plastic housing 11'. Thus, an interval exists between a portion of a bottom portion of the plastic housing 11' beyond the two engagement structures 2', such as a portion at the periphery of the bolt hole 111', and the engaged component 3'. As a result, the portion of the to-be-mounted component 1' at the periphery of the bolt hole 111' connected to the bolt fastener is suspended and unsupported, so that the strength of the portion of the plastic housing 11' of the to-be-mounted component 1' at the periphery of the bolt hole 111' is relatively low. When the bolt fastener passes through the bolt hole 111' of the plastic housing 11' to be fixed to the engaged component 3', the plastic housing 11' of the to-be-mounted component 1' has a risk of cracking at the bolt hole 111' and the periphery of the bolt hole 111', thereby affecting the mounting stability and normal operation of the to-be-mounted component 1'.

In view of the above problem in the conventional technology, as shown in FIG. 2, an electric power product is provided according to the present embodiment, including an engagement structure 2, a to-be-mounted component 3, and a reinforcement member 1. The to-be-mounted component 3 includes a mounting portion 31. The mounting portion 31 is connected to the engagement structure 2, and the engagement structure 2 is configured for engaging with an engaged component 4. The mounting portion 31 is provided with a first bolt hole 311, for example, the first bolt hole 311 may be formed in a side surface of the mounting portion 31. The reinforcement member 1 is mounted at a side of the mounting portion 31 away from the engagement structure 2. The reinforcement member 1 is provided with a second bolt hole 111 corresponding to a position of the first bolt hole 311. The mounting portion 31 is configured to be mounted to the engaged component 4 by inserting a fastener through the second bolt hole 111, the first bolt hole 311, and the engaged component 4.

In an embodiment, the mounting portion 31 of the to-be-mounted component 3 refers to a portion of the to-be-mounted component 3 connected to the engaged component 4. Thus, the mounting portion 31 of the to-be-mounted component 3 is configured to be engaged with the engaged component 4 through the engagement structure 2. The mounting portion 31 is provided with the first bolt hole 311 for the fastener to pass through, and the reinforcement member 1 may be mounted on the side of the mounting portion 31 away from the engagement structure 2, for example, on an upper side of the mounting portion 31. In this way, the fastener can sequentially pass through the second bolt hole 111 of the reinforcement member 1, the first bolt hole 311 of the mounting portion 31, and the engaged component 4 in the vertical direction, such that the mounting portion 31 and the engaged component 4 are fixed to each other through the fastener.

In the embodiment, the electric power product according to the present application mainly includes the engagement structure 2, the to-be-mounted component 3, and the reinforcement member 1. The electric power product can be connected to the engaged component 4 by the engagement structure and the fastener. Specifically, the mounting portion 31 of the to-be-mounted component 3 is connected to the engagement structure 2, and the engaged component 4 can be engaged with the engagement structure 2 by insertion along an insertion direction, such that the mounting portion 31 of the to-be-mounted component 3 is mounted to the engaged component 4 through the engagement structure 2. In an embodiment, after the mounting portion 31 and the engaged component 4 are assembled through the engagement structure 2, the engagement structure 2 is located between the mounting portion 31 and the engaged component 4. In this way, an interval exists between a portion of a side wall of the mounting portion 31 facing the engaged component 4 beyond the engagement structure 2 (such as a portion at the periphery of the first bolt hole 311) and the engaged component 4. The reinforcement member 1 is mounted on the side of the mounting portion 31 away from the engagement structure 2 (or the engaged component 4), that is, the thickness and the strength of the entire mounting portion 31 are increased from the side of the mounting portion 31 away from the engagement structure 2. The strength of the mounting portion 31 of the to-be-mounted component 3 at least at the periphery of the first bolt hole 311 is improved. When the position of the second bolt hole 111 of the reinforcement member 1 is in correspondence to the position of the first bolt hole 311 of the mounting portion 31, the fastener is sequentially inserted into the second bolt hole 111 of the reinforcement member 1, the first bolt hole 311 of the mounting portion 31, and the engaged component 4, so that the mounting portion 31 is fixed to the engaged component 4 by the fastener. Therefore, the risk of cracking of the mounting portion 31 of the to-be-mounted component 3 is effectively reduced, thereby ensuring the mounting stability of the to-be-mounted component 3. Furthermore, since the mounting portion 31 is not cracked, foreign matters cannot enter the interior of the to-be-mounted component 3 through the mounting portion 31, which ensures the normal operation of the to-be-mounted component 3.

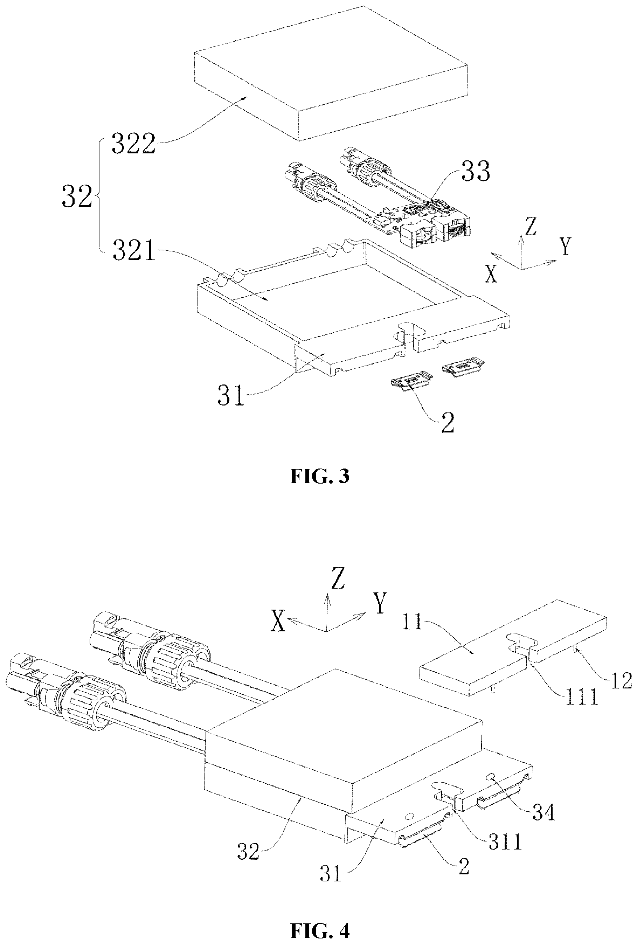

In an embodiment, as shown in FIG. 3, the to-be-mounted component 3 further includes a housing body 32 and a product body 33, and the product body 33 is mounted inside the housing body 32. The mounting portion 31 is connected to the housing body 32, and a surface of the mounting portion 31 facing the engagement structure 2 is higher than a surface of the housing body 32 facing the engaged component 4. The mounting portion 31 has a mounting area configured for engaging with the engagement structure 2.

Specifically, the product body 33 may be mounted inside the housing body 32 in the following way. For example, the housing body 32 may include an end cover 322 and a base 321, and the base 321 is of a housing structure. The product body 33 is mounted in the base 321, and the end cover 322 can be covered on the base 321 from above, so that the end cover 322 and the base 321 are connected in a sealed manner to package the product body 33, thereby protecting the product body 33. The product body 33 may include a combination of a circuit board, an electronic component or the like, and the specific structure of the product body 33 is not specifically limited.

The reinforcement member 1 is mounted on an upper portion of the mounting portion 31, and the engagement structure 2 is located below the mounting portion 31. Thus, the surface of the mounting portion 31 facing the engagement structure 2 refers to a bottom surface of the mounting portion 31. The to-be-mounted component 3 is mounted on an upper portion of the engaged component 4, that is, the engaged component 4 may be located below the to-be-mounted component 3. Therefore, the surface of the housing body 32 facing the engaged component 4 refers to a bottom surface of the housing body 32.

The mounting portion 31 may be connected to the housing body 32, for example, may be connected to the base 321. The mounting portion 31 and the base 321 of the housing body 32 may be of an integrally formed structure, thereby improving the assembling stability of the mounting portion 31 and the engaged component 4 through the engagement structure 2 and the fastener. The surface of the mounting portion 31 facing the engagement structure 2, for example, the bottom surface of the mounting portion 31, is higher than the surface of the housing body 32 facing the engaged component 4, for example, the bottom surface of the housing body 32. In other words, the bottom surface of the mounting portion 31 and the bottom surface of the housing body 32 are not in a same plane, such that the mounting area is formed between the bottom surface of the mounting portion 31 and the bottom surface of the housing body 32. The bottom surface of the mounting portion 31 may be provided with an engagement groove 312 for engaging with the engagement structure 2. In this way, the mounting area provides a space for the engagement structure 2 to be mounted in the engagement groove 312 on the bottom surface of the mounting portion 31. Correspondingly, after the to-be-mounted component 3 is mounted to the engaged component 4 through the mounting portion 31 and the engagement structure 2, other portions of the to-be-mounted component 3, such as the housing body 32, can contact the engaged component 4. Thus, the housing body 32 is supported from below by the engaged component 4, thereby further improving the mounting stability of the to-be-mounted component 3 with respect to the engaged component 4.

In an embodiment, as shown in FIG. 4, the reinforcement member 1 includes a reinforcement plate 11, and the reinforcement plate 11 is tightly attached to and is mounted to a side of the mounting portion 31 away from the mounting area.

In an embodiment, the reinforcement plate 11 is of a plate structure having a certain mechanical strength. For example, the reinforcement plate 11 may be a metal plate or a plastic plate having a certain mechanical strength. The specific material of the reinforcement plate is not specifically limited herein. The reinforcement plate 11 may be mounted on the upper portion of the mounting portion 31 by bonding, snap-fit or other means. The thickness of the mounting portion 31 refers to a size of the mounting portion 31 in the Z-axis direction of the coordinate system in FIG. 4.

In this embodiment, the reinforcement plate 11 is provided with the second bolt hole 111. When the reinforcement plate 11 is closely attached to and is mounted to the side of the mounting portion 31 away from the mounting area, such as the upper side of the mounting portion 31, the position of the second bolt hole 111 is in correspondence to the position of the first bolt hole 311. In this way, the thickness and the strength of the entire mounting portion 31 are increased from above the mounting portion 31, so that when the fastener passes through the second bolt hole 111 of the reinforcement plate 11 and the first bolt hole 311 of the mounting portion 31, the strength of the mounting portion 31 at the first bolt hole 311 and at the periphery of the first bolt hole 311 can be strengthened by the reinforcement plate 11, thereby effectively preventing the mounting portion 31 from cracking at the first bolt hole 311.

In an embodiment, as shown in FIG. 4, the reinforcement member 1 further includes a first positioning member 12, and a side of the reinforcement member 11 facing the mounting portion 31 is provided with the first positioning member 12. The mounting portion 31 is provided with a second positioning member 34, and the first positioning member 12 and the second positioning member 34 are connected to each other in a positioning manner. The position of the second bolt hole 111 is in correspondence to the position of the first bolt hole 311.

Specifically, the number and the structure of the first positioning member 12 match the number and the structure of the second positioning member 34. For example, in a case that the first positioning member 12 is a positioning protrusion, the second positioning member 34 is a positioning groove, as shown in FIG. 4. Alternatively, in a case that the first positioning member 12 is a positioning groove, the second positioning member 34 is a positioning protrusion.

In the embodiment, the first positioning member 12 is provided on the side of the reinforcement plate 11 facing the mounting portion 31, for example, on a bottom portion of the reinforcement plate 11, and the second positioning member 34 is provided on a side of the mounting portion 31 facing the reinforcement plate 11, for example, on a top portion of the mounting portion 31. The first positioning member 12 and the second positioning member 34 are connected to each other in a positioning manner when the reinforcement plate 11 is mounted on the upper portion of the mounting portion 31, so that the position of the second bolt hole 111 of the reinforcement plate 11 and the position of the first bolt hole 311 of the mounting portion 31 can quickly correspond with each other in the vertical direction, and the reinforcement plate 11 and the mounting portion 31 can be accurately mounted to each other without adjusting the position of the reinforcement plate 11 on the mounting portion 31, thereby facilitating the fastener to pass through the two bolt holes, so as to facilitate the assembling of the reinforcement member 1 and the mounting portion 31. In an embodiment, the reinforcement plate 11 is mounted to the mounting portion 31 by matching the first positioning member 12 with the second positioning member 34, and the reinforcement plate 11 and the mounting portion 31 are fixedly mounted to the engaged component 4 by the fastener. In this way, with the positioning connection between the two positioning members and the fixing effect of the fastener, the reinforcement plate 11 can be effectively prevented from shifting on the mounting portion 31, thereby improving the mounting stability of the reinforcement member 1 and the mounting portion 31.

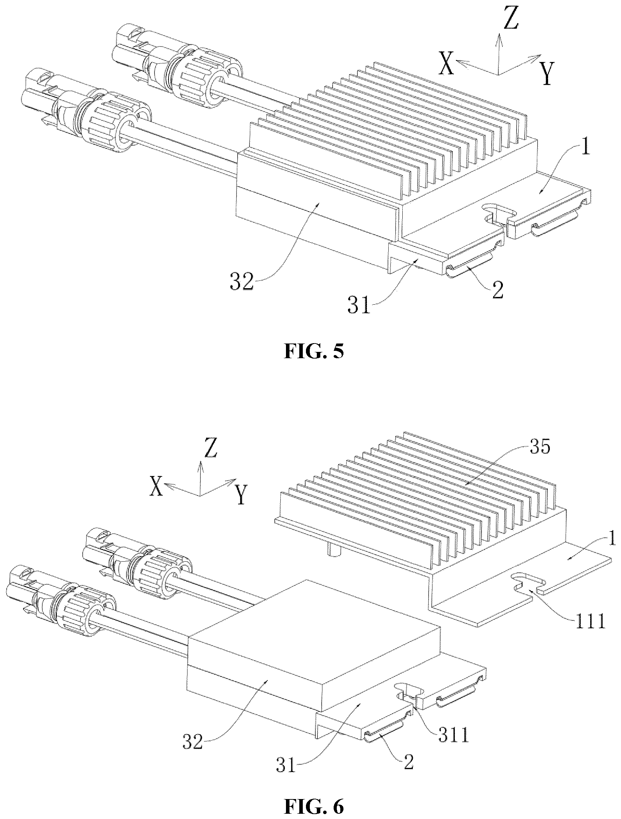

In an embodiment, as shown in FIG. 5 and FIG. 6, the to-be-mounted component 3 further includes a radiator 35. The radiator 35 is mounted to the housing body 32 and is configured to dissipate heat from the product body 33 in the housing body 32. The radiator 35 extends towards the mounting portion 31 to form the reinforcement member 1, and the reinforcement member 1 is tightly attached to the side of the mounting portion 31 away from the mounting area.

In an embodiment, the radiator 35 may be mounted on an outer surface of the housing body 32 to dissipate heat from the product body 33 in the housing body 32. The heat dissipation effect of the radiator 35 on the product body 33 may be improved in the following way. For example, the end cover 322 of the housing body 32 is provided with a through hole, and a bottom portion of the radiator 35 is provided with a thermal conductive structure. When the radiator 35 is mounted to the housing body 32, the thermal conductive structure passes through the through hole of the end cover 322 to contact and be connected to the product body 33, so that the heat produced by the operation of the product body 33 can be transferred to the radiator 35 through the thermal conductive structure, thereby improving the heat dissipation effect on the product body 33. The thermal conductive structure may be a metal structure that can conduct the heat, such as a thermal conductive plate, a thermal conductive pipe or the like, which is not specifically limited herein.

The structure extending from the radiator 35 may be the reinforcement member 1. The reinforcement member 1 is tightly attached to the mounting portion 31. For example, the reinforcement member 1 and the mounting portion 31 may be in direct contact, or may be pre-connected by bonding, so that the reinforcement member 1 does not shift on the mounting portion 31 when the fastener is being inserted.

In the embodiment, the reinforcement member 1 may be connected to the radiator 35 in the following way. For example, the radiator 35 is bent and extended towards the mounting portion 31 to form the reinforcement member 1. In this case, the reinforcement member 1 and the radiator 35 may be an integrated structure. The reinforcement member 1 may be connected to an upper surface of the mounting portion 31, so that the heat dissipation effect on the product body 33 is improved by the radiator 35. Furthermore, the extended structure of the radiator 35, such as the reinforcement member 1, is connected to the mounting portion 31, which is equivalent to increasing the thickness and the strength of the mounting portion 31 in the vertical direction from above. When the fastener passes through the second bolt hole 111 of the reinforcement member 1, the first bolt hole 311 of the mounting portion 31, and the engaged component 4 in the vertical direction, the strength of the mounting portion 31 at the first bolt hole 311 and the surrounding parts of the first bolt hole 311 can be effectively reinforced through the reinforcement member 1 above, which effectively prevents the mounting portion 31 from cracking.

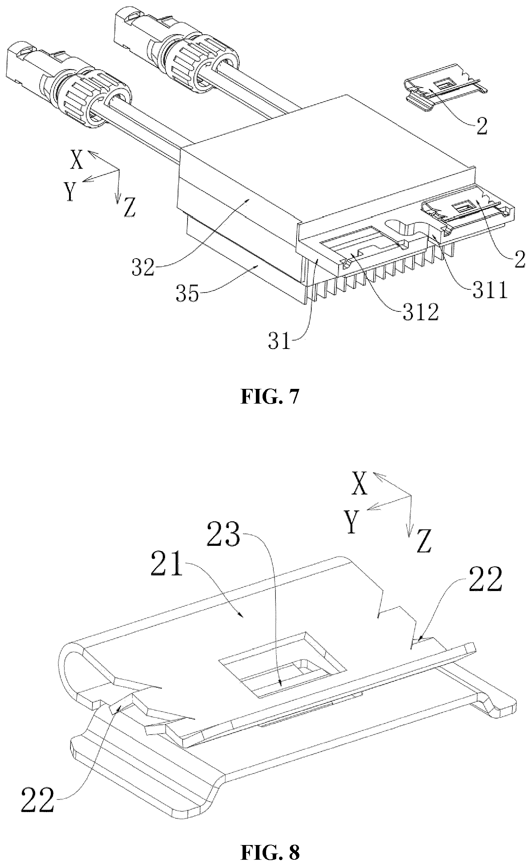

In an embodiment, as shown in FIG. 7, the engagement structure 2 has an engaging area, and the engaging area is configured for engaging with the engaged component 4. The engagement structure 2 and the first bolt hole 311 are spaced apart on the mounting portion 31 along a direction perpendicular to an engaging direction of the engaged component 4 along which the engaged component 4 is inserted into the engaging area.

The engaging direction may be the same as the positive direction of the X-axis of the coordinate system in FIG. 7, and the direction perpendicular to the engaging direction is parallel to the direction of the Y-axis of the coordinate system in FIG. 7. The engaged component 4 can be inserted into the engaging area of the engagement structure 2 along the engaging direction, such that the engaged component 4 and the engagement structure 2 are assembled.

The engagement structure 2 may be arranged on the mounting portion 31 in the following manners. For example, the mounting portion 31 is provided with at least one engagement groove 312. The engagement structure 2 may be engaged with the at least one engagement groove 312 by snap-fit, so as to be mounted to the mounting portion 31 by snap-fit, such that the engagement structure 2 and the mounting portion 31 can be quickly assembled.

In FIG. 7, the top portion of the mounting portion 31 is provided with two engagement grooves 312, so that two engagement structures 2 can be engaged with the corresponding engagement grooves 312, respectively.

In the embodiment, the engagement structure 2 and the first bolt hole 311 may be arranged on the mounting portion 31 and spaced apart from each other along the direction perpendicular to the engaging direction. In other words, the engagement structure 2 on the mounting portion 31 is engaged with the engaged component 4 below, and the first bolt hole 311 in the mounting portion 31 is connected to the engaged component 4 by the fastener, which means that an area of the connection portion between the mounting portion 31 and the engaged component 4 in the direction perpendicular to the engaging direction can be increased, thereby improving the assembling stability of the mounting portion 31 of the to-be-mounted component 3 and the engaged component 4.

In an embodiment, the first bolt hole 311 is located between the two engagement grooves 312, so that along the direction perpendicular to the engaging direction, the two engagement structures 2 on the mounting portion 31 are engaged with the engaged component 4. By passing the fastener through the second bolt hole 111 of the reinforcement member 1, the first bolt hole 311 of the mounting portion 31, and the engaged component 4 between the two engagement grooves 312, the connection area between the mounting portion 31 and the engaged component 4 is further increased, thereby improving the assembling stability of the mounting portion 31 and the engaged component 4.

In an embodiment, as shown in FIG. 7 and FIG. 8, the engagement structure 2 includes an engagement body 21, and the engagement body 21 includes two straight plate portions and one curved plate portion. Two opposite ends of the curved plate portion are respectively connected to the two straight plate portions, and the two straight plate portions and the curved plate portion enclose to form the engaging area. A side of one of the two straight plate portions away from the other one of the two straight plate portions is engaged with the mounting portion 31.

The engagement structure includes the engagement body 21, and the engagement body 21 may be of the following structure. For example, the engagement body 21 includes one curved plate portion, and two straight plate portions arranged in the vertical direction. It can be understood that, the engagement body 21 is formed by bending a middle portion of a plate and portions adjacent to the middle portion by more than 180 degrees. The curved plate portion refers to the bent portion of the engagement body 21, and the two straight plate portions refers to portions of the engagement body 21 except for the curved plate portion, for example, an upper portion and a lower portion of the engagement body 21 are the straight plate portions. Each of the two straight plate portions may be of a flat plate structure, or may be of a curved plate structure, i.e. a plate structure that is curved to some extent. The engagement body 21 has the engaging area, that is, the area enclosed by the curved plate portion and the two straight plate portions is the engaging area.

The engagement structure 2 may be of the following specific structure to be engaged with the engagement groove 312 on the mounting portion 31. For example, a side of one of the two straight plate portions (for example, a lower straight plate portion) away from the other one of the two straight plate portions (for example, an upper straight plate portion) is engaged with the mounting portion 31 in the following manner. Specifically, two opposite ends of the lower straight plate portion are bent outwardly and extended along the direction perpendicular to the engaging direction to form an insertion sheet, and the insertion sheet can be engaged with the engagement groove 312 of the mounting portion by snap-fit.

In an embodiment, as shown in FIG. 8 to FIG. 11, the engagement structure 2 further includes a first engagement part 22 and a second engagement part 23. One of the two straight plate portions of the engagement body 21 away from the mounting portion 31 is provided with the first engagement part 22 and the second engagement part 23 along the direction perpendicular to the engaging direction. When the engaged component 4 is inserted into the engaging area, both the first engagement part 22 and the second engagement part 23 abut against the engaged component 4.

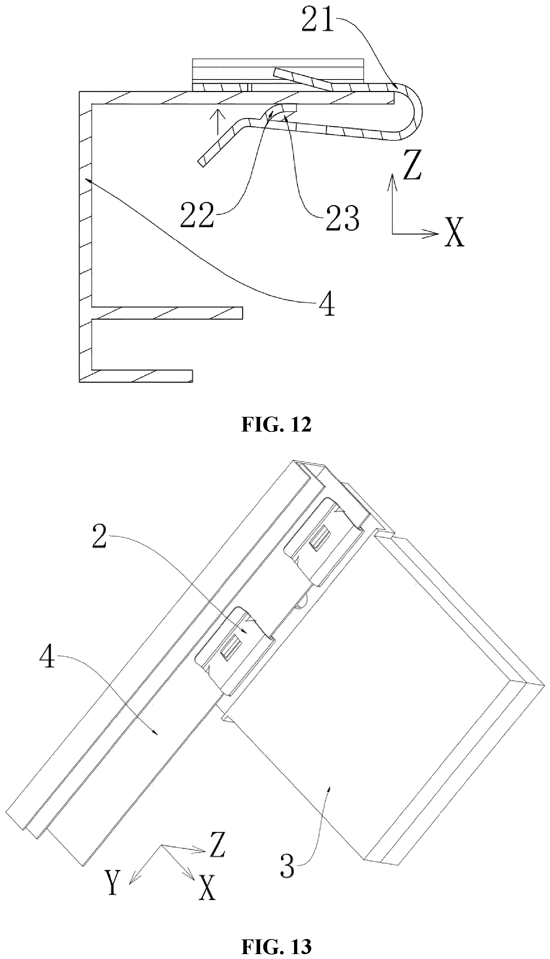

The first engagement part 22 and the second engagement part 23 are spaced apart and arranged on the lower straight plate portion of the engagement body 21. When the engaged component 4 enters the engaging area of the engagement body 21 along the engaging direction, the first engagement part 22 and the second engagement part 23 can apply an upward pressure (indicated by an unidirectional arrow in FIG. 12) to the engaged component 4, such as a frame of a photovoltaic panel, from above, thereby realizing the engagement of the engagement structure 2 and the engaged component 4. In FIG. 8 and FIG. 12, the positive direction of the Z-axis of the coordinate system indicates the upper side, the negative direction of the Z-axis of the coordinate system indicates the lower side, and the direction perpendicular to the engaging direction along which the engaged component 4 is inserted into the engaging area may be the same as the Y-axis of the coordinate system. The first engagement part 22 and the second engagement part 23 may be distributed on the engagement body 21 along the left-right direction.

The first engagement part 22 is bent and extends upwards from the engagement body 21 towards the engaged component 4. The first engagement part 22 may be of a triangular structure to be in point contact with the engaged component 4.

The position of the first engagement part 22 may be arranged as follows. At least one first engagement part 22 is provided on an end portion of the lower straight plate portion of the engagement body 21 along the direction perpendicular to the engaging direction. The position of the second engagement part 23 may be arranged as follows. The number of the second engagement part 23 is at least one, and the at least one second engagement part 23 is arranged in an area between two ends of the lower straight plate portion of the engagement body 21 along the direction perpendicular to the engaging direction.

In the embodiment, when the engagement structure 2 is being assembled with the to-be-mounted component 3 and the engaged component 4, since the engagement body 21 has the engaging area, the engagement body 21 is engaged with the engagement groove 312 of the mounting portion 31 of the to-be-mounted component 3 first, and then, the engaged component 4 is inserted into the engaging area of the engagement body 21 along the engaging direction. In this way, the first engagement part 22 and the second engagement part 23 of the engagement body 21 abut against the engaged component 4, so that the engaged component 4 is engaged and fixed in the engaging area of the engagement body 21. Since the first engagement part 22 and the second engagement part 23 are distributed on the engagement body 21 along the direction perpendicular to the engaging direction, the engagement area between the engagement structure 2 and the engaged component 4 is effectively increased, thereby improving the engagement reliability and the mounting stability of the engagement structure 2 and the engaged component 4.

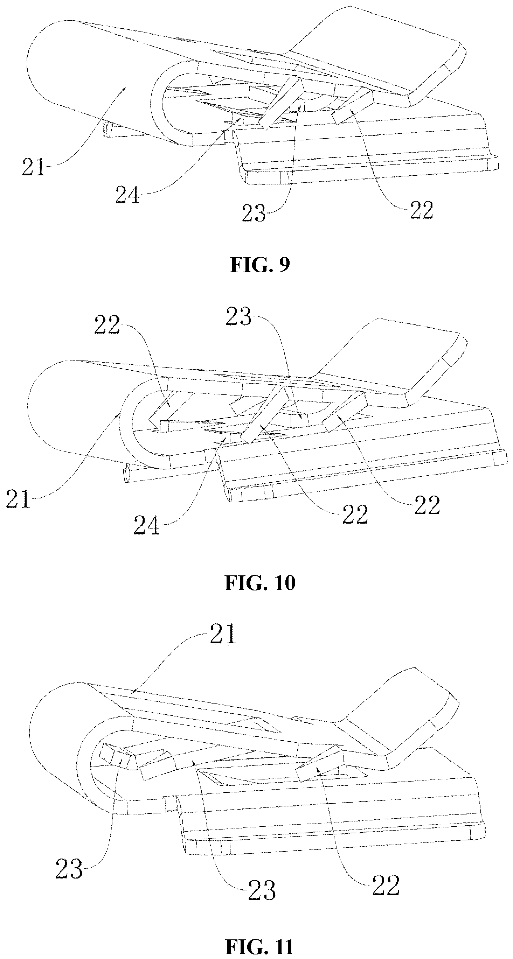

In an embodiment, as shown in FIG. 11, the engagement structure 2 includes at least two second engagement parts 23. The one of the two straight plate portions of the engagement body 21 away from the mounting portion 31 is provided with the at least two second engagement parts 23 that are spaced apart along the direction perpendicular to the engaging direction. The at least two second engagement parts 23 are bent and extended from the engagement body 21 towards the engaged component 4.

The at least two second engagement parts 23 may have same size and shape, or may have different sizes and shapes. The at least two second engagement parts 23 may contact the engaged component 4 in the following manner. For example, at least some of the at least two second engagement parts 23 are in line contact with the engaged component 4, or at least some of the at least two second engagement parts 23 are in surface contact with the engaged component 4, or at least some of the at least two second engagement parts 23 are in point contact with the engaged component 4.

In the embodiment, the at least two second engagement parts 23 are arranged on the lower straight plate portion of the engagement body 21 in the direction perpendicular to the engaging direction. In this case, the at least two second engagement parts 23 can tightly press the engaged component 4 from a middle portion of the engagement body 21 simultaneously, thereby equivalently increasing the engagement length or the engagement area of the engagement structure 2 and the engaged component 4 in the direction (the Y-axis direction in FIG. 1) perpendicular to the engaging direction, such that the assembling stability of the engagement structure 2 and the engaged component 4 is improved. Moreover, even if some of the at least two second engagement parts 23 are broken or fail to tightly press the engaged component 4, other of the at least two second engagement parts 23 can tightly press the engaged component 4, which further improves the assembling stability of the engagement structure 2 and the engaged component 4.

In an embodiment, as shown in FIG. 11, an end portion of at least one of the at least two second engagement parts 23 away from the engagement body 21 is parallel to the engaged component 4, and a size of at least another one of the at least two second engagement parts 23 gradually decreases from the engagement body 21 to the engaged component 4.

The structure of the second engagement part 23 may be different from the structure of the first engagement part 22. For example, the end portion of the at least one of the second engagement parts 23 away from the engagement body 21 is parallel to the engaged component 4. In this case, the second engagement part 23 may be of a curved block structure that is curved to some extent, so that when the engaged component 4 is inserted into the engaging area of the engagement body 21, the second engagement part 23 of the curved block structure is in surface contact with the engaged component 4. Thus, the engagement area of the second engagement part 23 and the engaged component 4 can be increased, so as to improve the engagement stability between the second engagement part 23 and the engaged component 4.

The second engagement parts 23 may be of a same structure as the first engagement part 22. For example, the size of the at least another one of the second engagement parts 23 gradually decreases from the engagement body 21 to the engaged component 4. In this case, the second engagement part 23 may be of a triangular spring sheet structure, so that when the engaged component 4 is inserted into the engaging area of the engagement body 21, the second engagement part 23 of the triangular spring sheet structure is in point contact with the engaged component 4. Thus, the second engagement part 23 is equivalent to a barb structure to improve the engagement strength of the engagement structure 2 and the engaged component 4.

In the embodiment, at least one of the second engagement parts 23 is engaged with the engaged component 4 in a surface contact manner, and at least another one of the second engagement parts 23 is engaged with the engaged component 4 in a point contact manner. Therefore, if the second engagement part 23 of one type fails, the second engagement part 23 of another type still works, thereby further improving the engagement stability of the engagement structure 2 and the engaged component 4.

In an embodiment, as shown in FIG. 9 and FIG. 10, the engagement body 21 further includes a third engagement part 24, and the other one of the two straight plate portions of the engagement body 21 close to the mounting portion 31 is provided with the third engagement part 24. The third engagement part 24 is bent and extended from the engagement body 21 towards the engaged component 4, and the third engagement part 24 is configured to abut against the engaged component 4.

The third engagement part 24 may be arranged on the one of the two straight plate portions of the engagement body 21 close to the mounting portion 31. The third engagement part 24 may be of a triangular spring sheet structure, and the third engagement part 24 is engaged with the engaged component 4 in a point contact manner. Alternatively, an included angle is formed between an entire surface of the third engagement part 24 facing the engaged component 4 and the engaged component 4 (as shown in FIG. 9 and FIG. 10), the third engagement part 24 may be basically of a rectangular structure, the surface of the third engagement part 24 facing the engaged component is an inclined surface, and the third engagement part 24 is engaged with the engaged component 4 in a line contact manner.

In the embodiment, the first engagement part 22 and the second engagement part 23 may be arranged on the same one of the two straight plate portions of the engagement body 21. The third engagement part 24 may be arranged on the other one of the two straight plate portions of the engagement body 21, and the third engagement part 24 is bent and extended from the engagement body 21 towards the engaged component 4. In this way, when the engaged component 4 is inserted into the engaging area of the engagement body 21 along the engaging direction, the first engagement part 22 and the second engagement part 23 apply the upward pressure (as shown in FIG. 12) on the engaged component 4, and the third engagement part 24 applies a downward pressure to the engaged component 4. If an engagement part on one side of the engaged component 4 fails, for example, the first engagement part 22 and the second engagement parts 23 on a lower side of the engaged component 4 fail, another engagement part on the opposite side of the engaged component 4 still works for engagement, for example, the third engagement part 24 on an upper side of the engaged component 4 still works for engagement. In other words, the first engagement part 22 and the second engagement parts 23 apply the pressure to the engaged component 4 from below, and the third engagement part 24 applies the pressure to the engaged component 4 from above, thereby improving the reliability of the assembly of the mounting portion 31 of the to-be-mounted component 3 and the engaged component 4 through the three types of engagement parts of the engagement structure 2.

A photovoltaic power generation system is provided according to an embodiment of the present application, including an engaged component 4 and the electric power product described above.

In the embodiment, the engaged component 4 may be a frame of a photovoltaic panel in the photovoltaic power generation system, or may be other structures, which is specifically determined according to the type and mounting position of the to-be-mounted component 3. Thus, the engaged component 4 is not specifically shown herein.

When the to-be-mounted component 3 is assembled with the engaged component 4 through the engagement structure 2 and the fastener, the engaged component 4 has an engagement portion corresponding to the engagement structure 2, and a hole structure or a groove structure for connection to the fastener.

The engaged component 4 may be connected to the mounting portion 31 by the fastener in the following ways. For example, the engaged component 4 has a threaded hole, and the fastener may be of a bolt structure having external threads, so that the fastener vertically passes through the second bolt hole 111 of the reinforcement member 1 and the first bolt hole 311 of the mounting portion 31 in sequence, and then is screwed to the threaded hole of the engaged component 4. Alternatively, the engaged component 4 is provided with a groove structure, and an end face of the groove structure in an extension direction of the groove structure may be of a T-slot. The fastener includes a nut structure and a T-bolt. A head end of the T-bolt is embedded into the groove structure of the engaged component 4, and a tail end of the T-bolt sequentially passes through the first bolt hole 311 of the mounting portion 31 and the second bolt hole 111 of the reinforcement member 1 from below, so as to be connected to the nut structure above the reinforcement plate 11. In this way, the engaged component 4 can also be connected to the mounting portion 31 by the fastener.

Exemplarily, components of the photovoltaic power generation system may be assembled in the following ways. For example, the housing body 32 and the mounting portion 31 may be an integrally formed structure, the engagement structure 2 may be mounted to the mounting portion 31, and the engaged component 4 may be engaged with the engagement structure 2 along the engaging direction. Alternatively, the mounting portion 31 and the engagement structure 2 are an integrally formed structure, and the mounting portion 31 is mounted to the housing body 32 of the to-be-mounted component 3. Alternatively, the housing body 32 and the mounting portion 31 of the to-be-mounted component 3, and the engagement structure 2 are separately formed, and are first assembled into the electric power product, and then, the electric power product is assembled with the engaged component 4. Alternatively, the housing body 32 and the mounting portion 31 of the to-be-mounted component 3, and the engagement structure 2 are integrally formed, the engaged component 4 is engaged with the engagement structure 2 along the engaging direction, and then, the fastener passes through the second bolt hole 111, the first bolt hole 311, and the engaged component 4 to realize the assembly of the to-be-mounted component 3 and the engaged component 4.

Compared with the conventional technology, the photovoltaic power generation system according to the embodiment has the same beneficial effects as the above electric power product, which is not described in detail herein.

Although the present application is disclosed hereinabove, the protection scope of the present application is not limited thereto. Many variations and modifications may be made by those skilled in the art without departing from the spirit and scope of the present application, and these variations and modifications shall fall into the protection scope of the present application.

## Claims

1. An electric power product, comprising an engagement structure (2), a to-be-mounted component (3), and a reinforcement member (1), wherein
the to-be-mounted component (3) comprises a mounting portion (31), the mounting portion (31) is connected to the engagement structure (2), and the engagement structure (2) is configured for engaging with an engaged component (4);
the mounting portion (31) is provided with a first bolt hole (311), and the reinforcement member (1) is mounted on a side of the mounting portion (31) away from the engagement structure (2); and
the reinforcement member (1) is provided with a second bolt hole (111) corresponding to a position of the first bolt hole (311), and the mounting portion (31) is configured to be mounted to the engaged component (4) by passing a fastener through the second bolt hole (111), the first bolt hole (311), and the engaged component (4).

2. The electric power product according to claim 1, wherein the to-be-mounted component (3) further comprises a housing body (32) and a product body (33), and the product body (33) is mounted inside the housing body (32); and the mounting portion (31) is connected to the housing body (32), a surface of the mounting portion (31) facing the engagement structure (2) is higher than a surface of the housing body (32) facing the engaged component (4), and the mounting portion (31) has a mounting area for engaging with the engagement structure (2).

3. The electric power product according to claim 2, wherein the reinforcement member (1) comprises a reinforcement plate (11), and the reinforcement plate (11) is attached to and is mounted to a side of the mounting portion (31) away from the mounting area.

4. The electric power product according to claim 3, wherein the reinforcement member (1) further comprises a first positioning member (12), and the first positioning member (12) is provided on a side of the reinforcement plate (11) facing the mounting portion (31); and the mounting portion (31) is provided with a second positioning member (34), the first positioning member (12) and the second positioning member (34) are connected to each other in a positioning manner, and the position of the second bolt hole (111) is in correspondence to the position of the first bolt hole (311).

5. The electric power product according to claim 2, wherein the to-be-mounted component (3) further comprises a radiator (35), and the radiator (35) is mounted to the housing body (32) and is configured to dissipate heat from the product body (33) in the housing body (32); and the radiator (35) extends towards the mounting portion (31) to form the reinforcement member (1), and the reinforcement member (1) is attached to a side of the mounting portion (31) away from the mounting area.

6. The electric power product according to any one of claims 2 to 5, wherein the engagement structure (2) has an engaging area, the engaging area is configured for engaging with the engaged component (4), and the engagement structure (2) and the first bolt hole (311) are spaced apart on the mounting portion (31) along a direction perpendicular to an engaging direction along which the engaged component (4) is inserted into the engaging area.

7. The electric power product according to claim 6, wherein the engagement structure (2) comprises an engagement body (21), the engagement body (21) comprises two straight plate portions and a curved plate portion, two opposite ends of the curved plate portion are respectively connected to the two straight plate portions, the two straight plate portions and the curved plate portion enclose to form the engaging area, and a side of one of the two straight plate portions away from the other one of the two straight plate portions is engaged with the mounting portion (31).

8. The electric power product according to claim 7, wherein the engagement structure (2) further comprises a first engagement part (22) and a second engagement part (23), the first engagement part (22) and the second engagement part (23) are arranged on one of the two straight plate portions of the engagement body (21) away from the mounting portion (31) along the direction perpendicular to the engaging direction, and when the engaged component (4) is inserted into the engaging area, both the first engagement part (22) and the second engagement part (23) abut against the engaged component (4).

9. The electric power product according to claim 8, wherein the engagement structure (2) comprises at least two second engagement parts (23), the at least two second engagement parts (23) are spaced apart along the direction perpendicular to the engaging direction and are arranged on the one of the two straight plate portions of the engagement body (21) away from the mounting portion (31), and the at least two second engagement parts (23) are bent and extended from the engagement body (21) towards the engaged component (4).

10. The electric power product according to claim 9, wherein an end portion of at least one of the at least two second engagement parts (23) away from the engagement body (21) is parallel to the engaged component (4), and a size of at least another one of the at least two second engagement parts (23) gradually decreases from the engagement body (21) to the engaged component (4).

11. The electric power product according to claim 8, wherein the engagement body (21) further comprises a third engagement part (24), the third engagement part (24) is provided on the other one of the two straight plate portions of the engagement body (21) close to the mounting portion (31), the third engagement part (24) is bent and extended from the engagement body (21) towards the engaged component (4), and the third engagement part (24) is configured to abut against the engaged component (4).

12. A photovoltaic power generation system, comprising an engaged component (4) and the electric power product according to any one of claims 1 to 11.
